# EUROPEAN PATENT APPLICATION

(11) **EP 4 276 900 A1**
(43) Date of publication of application: **15.11.2023**
(21) Application number: 22173264.7
(22) Date of filing: 13.05.2022
(51) Int. Cl.: H01L 23/498

(54) **IC SUBSTRATE HAVING CENTRAL SECTION WITH VERTICALLY STACKED FUNCTIONAL VOLUME SECTIONS**

(71) Applicant: AT & S Austria Technologie & Systemtechnik Aktiengesellschaft, 8700 Leoben (AT)
(72) Inventor: Gavagnin, Marco, 8700 Leoben (AT); Leitgeb, Markus, 8793 Trofaiach (AT); Oggioni, Stefano Sergio, 8700 Leoben (AT)
(74) Representative: Dilg, Haeusler, Schindelmann Patentanwaltsgesellschaft mbH

(57) **Abstract**

An integrated circuit substrate (100) for surface mounting an integrated circuit component (102) thereon, wherein the integrated circuit substrate (100) comprises a central section (104), and at least two vertically stacked functional volume sections (106) in the central section (104), wherein a pitch (D) at an integrated circuit component mounting side (108) of the integrated circuit substrate (100) is not more than 150 µm.

## Description

### Field of the Invention

The invention relates to an integrated circuit substrate, to an electronic device, and to a method of manufacturing an integrated circuit substrate.

### Technological Background

In the context of growing product functionalities of component carriers equipped with one or more components and increasing miniaturization of such components as well as a rising number of components to be connected to the component carriers such as printed circuit boards or integrated circuit substrates, increasingly more powerful array-like components or packages having several components are being employed, which have a plurality of contacts or connections, with ever smaller spacing between these contacts. In particular, component carriers shall be mechanically robust and electrically reliable so as to be operable even under harsh conditions.

Conventional approaches of forming component carriers are still challenging in particular what concerns integrated circuit (IC) substrates. In comparison with printed circuit boards, IC substrates are smaller and have a smaller pitch.

### Summary of the Invention

There may be a need to form a compact and reliable IC substrate with flexible and high degree of functionality.

According to an exemplary embodiment of the invention, an integrated circuit substrate for surface mounting an integrated circuit component thereon is provided, wherein the integrated circuit substrate comprises a central section (for instance a fully cured core), and at least two vertically stacked functional volume sections in the central section, wherein a pitch at an integrated circuit component mounting side of the integrated circuit substrate is not more than 150 µm (for example not more than 100 µm, in particular not more than 50 µm).

According to another exemplary embodiment of the invention, an electronic device is provided which comprises an integrated circuit substrate having the above-mentioned features.

According to another exemplary embodiment of the invention, a method of manufacturing an integrated circuit substrate for surface mounting an integrated circuit component thereon is provided, wherein the method comprises providing a central section, vertically stacking at least two functional volume sections in the central section, and forming a pitch at an integrated circuit component mounting side of the integrated circuit substrate being not more than 150 µm.

In the context of the present application, the term "integrated circuit substrate" (IC substrate) may particularly denote a component carrier having a size and a pitch adjusted to the requirements of an integrated circuit component (in particular a semiconductor chip) mounted thereon. An IC substrate may be a, in relation to a PCB, comparably small component carrier onto which one or more integrated circuit components may be mounted and that may act as a connection body between one or more chip(s) and a PCB. For instance, an IC substrate may have substantially the same size as an electronic component to be mounted thereon (for instance in case of a Chip Scale Package (CSP)). In another embodiment, the IC substrate may be larger than the assigned component (for instance in a flip chip ball grid array, FCBGA, configuration). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections are arranged within the IC substrate and can be used to provide electrical, thermal and/or mechanical connections of housed components or unhoused components (such as bare dies), particularly of IC chips, with a printed circuit board or interposer. A dielectric part of an IC substrate may be composed of resin with reinforcing particles (such as reinforcing spheres, in particular glass spheres). It is also possible that the dielectric part of an IC substrate comprises a hybrid construction, for instance a combination of prepreg and an ABF (Ajinomoto ^{®} Build-up Film).

In the context of the present application, the term "central section" may particularly denote a support body functioning for mechanically supporting a surface mounted integrated circuit component and for accommodating stacked functional volume sections. For example, the central section may be a core comprising fully cured organic dielectric material, such as a resin like epoxy resin. Dielectric core material may comprise, additionally or alternatively, any of the materials mentioned in the below list as examples for the at least one electrically insulating layer structure. It is also possible that the central section comprises a ceramic, a semiconductor material, or glass. Functional volume sections may be integrally formed with the central section or may be embedded as inlays in a hole of the central section.

In the context of the present application, the term "functional volume section" may particularly denote any volume region inside the central section being configured for providing at least one dedicated technical function. The functional volume section may be formed as an integral part of the central section (for instance by build-up processes and/or embedding processes). However, it is also possible that a functional volume section is a functional inlay which may be pre-fabricated and may then be inserted in a readily manufactured condition into a hole of the central section. Although a functional volume section may comprise one or more components, a functional volume section may be different from a component only.

In the context of the present application, the term "vertically stacked functional volume section" may particularly denote functional volume sections being arranged on top of each other inside of the central section. For example, stacked functional volume sections may extend all over the same width or area in a horizontal plane. It is however also possible that stacked volume sections extend over different spatial ranges within a horizontal plane, for instance are arranged with mutual horizontal displacement. Optionally, it may also be possible that the central section has, in addition to the vertically stacked functional volume sections, laterally arranged functional volume sections. Each functional volume section may be considered as a functional module, wherein multiple of such functional modules can be freely combined for designing an IC substrate with surface mounted electronic component(s) providing a desired function or functional combination. Different functional volume sections may fulfill different functions and may thus be spatially delimited from each other accordingly.

In the context of the present application, the term "pitch", in particular "line pitch", may particularly denote the distance between corresponding edges of two adjacent metal structures. When said metal structures are pads at a main surface of the integrated circuit substrate, the pitch may be the distance between an edge on one side of a first pad and the corresponding edge on one side of a second pad arranged next to said first pad.

In the context of the present application, the term "integrated circuit component mounting side" may particularly denote a main surface of the integrated circuit substrate at which the integrated circuit substrate is to be connected with at least one surface mounted component having a monolithically integrated circuit. Said integrated circuit component mounting side may be arranged at an opposing main surface of the integrated circuit substrate compared with a mounting base mounting side of the integrated circuit substrate on which the integrated circuit substrate is to be mounted on a mounting base, such as a printed circuit board (PCB) or an interposer.

In the context of the present application, the term "electronic device" may particularly denote an arrangement of an integrated circuit substrate with at least one surface mounted integrated circuit component and/or mounted on a mounting base (for example a PCB).

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

According to an exemplary embodiment of the invention, an IC substrate architecture is provided in which a central section has vertically stacked functional volume sections. A pitch of not more than 150 µm is a characteristic of an IC substrate in comparison with a PCB having a larger pitch. Advantageously, the central section (for example a core) may be used in addition to its mechanical support function and optionally as a redistribution structure for providing additional functions achieved by monolithically integrating or embedding functional volume sections for providing said functions above each other in the central section. By taking this measure, a highly flexible construction set is provided for manufacturing IC substrates with specific application-defined or user-defined functional setup. At the same time, such IC substrates may be manufactured with low effort, since simple stacking and/or vertical build-up procedures may be sufficient for implementing any desired functional volume section in the IC substrate. Consequently, a multifunctional core with vertically stacked functional volume sections may be provided being consequently highly compact. In comparison with conventional approaches, a conventional core may be split into different functional volume sections to thereby achieve an augmented density in terms of wiring and functionality.

### Detailed Description of Exemplary Embodiments

In the following, further exemplary embodiments of the IC substrate, the electronic device and the method will be explained.

In an embodiment, one, several or all of the following functions may be implemented in the various functional volume sections:
- Power Functionality:
   - Provide capacitances
   - Embed passive components (such as filter, capacitors, inductors, resistors)
   - Embedding active components (for example a DC-DC converter, a buck converter, a power management integrated circuit)
- Security Functionality for tamper-proof configuration:
   - Embedded Memories
   - Crypto Engines
   - VPD (Vital Product Data) storage unit
   - Embedding of clocks (for example quartz crystal, oscillator)
- Thermal:
   - copper coin
   - Thick copper layers
   - Copper vias with different diameters
- Electro-optical Functionalities:
   - Conversion
   - Transmission
   - Connection to an outer optical fiber (for instance for creating a connector)
- Optical Communication:
   - Mirrors
   - Waveguide
- Shielding structures:
   - Electromagnetic compatibility (EMC)
   - Security (anti-tamper)
   - Identification
- Current Capabilities/Ampacity:
   - Different drill diameters within cores
   - Thick copper layers

In an embodiment, the central section is a fully cured core. For example, such a core may comprise cured resin (such as epoxy resin), optionally comprising reinforcing particles (such as glass particles, for instance shaped as spheres). In particular, such a core may be made of FR4 material. A fully cured core may provide high mechanical stability and may be appropriate for the formation of one or more holes therein, or for a build-up of vertically stacked functional volume sections. Moreover, a core may also comprise electrically conductive material, for instance metal, in particular copper.

In an embodiment, the central section comprises at least three vertically stacked functional volume sections. Thus, even sophisticated electronic functionality may be integrated by three or more vertically stacked functional volume sections. Preferably, said at least three functional volume sections may be interconnected for functionally cooperating with each other. For instance, a signal propagating between a bottom side and a top side of the IC substrate (i.e. between a mounting base and a surface mounted electronic component) may undergo a sequential functional processing by the at least three vertically stacked functional volume sections in a hierarchical order.

Although an embodiment with at least three vertically stacked functional volume sections may be advantageous, other embodiments may use only two vertically stacked functional volume sections, which may lead to a highly compact design.

In an embodiment, the integrated circuit substrate comprises a laminated layer stack formed on one main surface of the central section. Lamination may denote the process of connecting the layer stack internally and/or to the central section with its functional volume sections by the application of pressure and/or heat. By laminating a layer stack on the upper or lower main surface of the central section including its integrated functional volume sections, further functionality may be added, for instance functionality of a redistribution structure or of a locally increased integration density.

In an embodiment, the integrated circuit substrate comprises a further laminated layer stack formed on an opposing other main surface of the central section. In particular, it may be possible that there is only one laminated layer stack on the bottom or that there is only one laminated layer stack on the top of the central section including functional volume sections. In yet another embodiment, there may be a laminated layer stack on the bottom and another laminated layer stack on the top of the central section including the functional volume sections.

In an embodiment, the laminated layer stack and/or the further laminated layer stack has/have a different integration density than the central section. For example, the integration density of the laminated layer stack (in particular on the IC-type component mounting side of the IC substrate) may be higher than the integration density of the central section so that the top side pitch matches with a high pitch size of a surface mounted electronic component. It is however also possible that the integration density of a laminated layer stack may be lower than the integration density of the central section, for example in a scenario in which an embedded component within the central section is a bridge or a silicon interposer or another entity with higher integration density.

In an embodiment, a laminated layer stack on the mounting base mounting side has a lower integration density than a further laminated layer stack on the integrated circuit component mounting side. In such an advantageous configuration, a laminated layer stack at the integrated circuit component mounting side may be adapted to a finer pitch of one or more surface mounted IC components at the integrated circuit component mounting side. Correspondingly, a further laminated layer stack at a mounting base mounting side may be adapted to a larger pitch of a printed circuit board at the mounting base mounting side. Thus, the laminated layer stacks may contribute to an adjustment or matching between the different characteristic pitches at the two opposing main surfaces of the IC substrate. Thus, upper build-up layers may have finer, denser or tighter geometries (i.e. smaller dimensions and/or more features per volume or area) than the ones present on the bottom side.

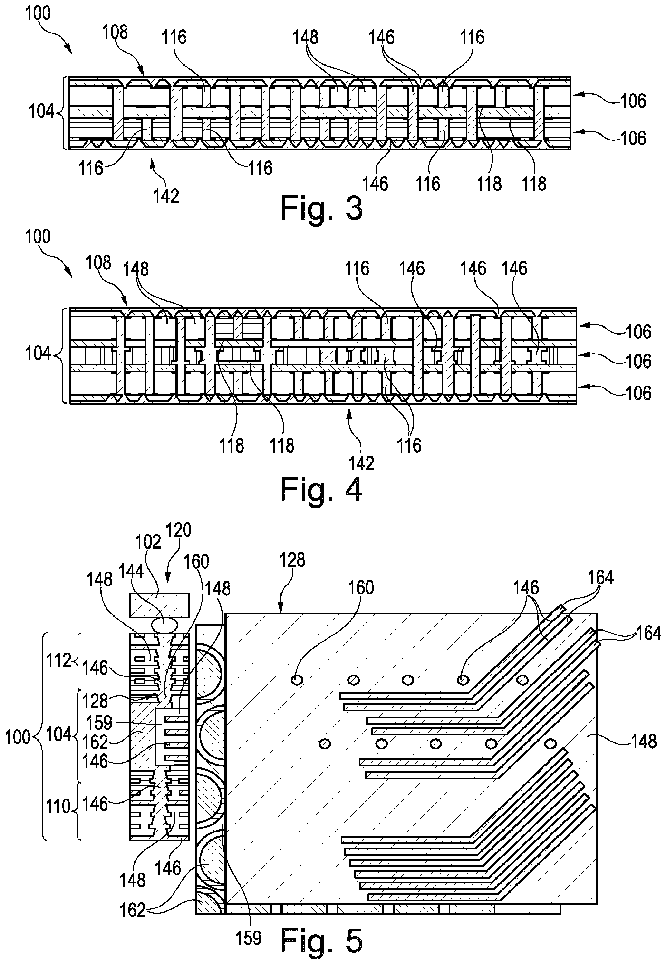

In an embodiment, an interface layer (see reference sign 128 in Figure 5) may be provided in an interface region between the central section and the laminated layer stack, which interface layer decouples geometrically a position of (in particular larger) through holes of the central section with respect to (in particular smaller) laser vias of the laminated layer stack. Thus, an interface layer may be provided as a top portion of the central section for decoupling geometrically the positioning of (in particular plated) through holes to a respective placement of the (in particular plated) laser via surfacing on the interface layer. This may preserve the use of the interface layer as appropriate reference plane.

In an embodiment, at least one of the functional volume sections extends vertically over a plurality of stacked layer structures. Extending over a plurality of stacked layer structures may mean that a respective functional volume section ranges spatially from an initial layer structure up to another final layer structure and thereby covers two or more layer structures (in particular at least four layer structures) in a vertical direction.

In an embodiment, at least one of the functional volume sections comprises a vertical through connection extending vertically only through part of the thickness of the central section. Such a vertical through connection extending vertically only through part of the thickness of the central section distinguishes from a metal-filled through hole crossing the whole central section in vertical direction.

In an embodiment, at least one of the functional volume sections comprises a horizontally extending wiring structure. Such a horizontally extending wiring structure may function for conducting electric current within a horizontal plane before transferring said current to another plane via a vertical through connection being coupled with said horizontal wiring structure.

In an embodiment, at least one of the functional volume sections is configured to provide a power conversion function, in particular a direct current-direct current (DC-DC)-converter function. Descriptively speaking, a core-integrated DC-DC converter may be provided. Such a power conversion functionality may in particular be achieved by embedding one or more corresponding active components (for instance a DC-DC converter chip) and/or passive components (for example at least one inductor) in the respective functional volume section.

In an embodiment, at least one of the functional volume sections is configured to provide a power distribution function, in particular a redistribution structure function. For example, a redistribution layer (RDL) may be integrated in a functional volume section for creating a transfer between larger and smaller pitch. Thus, a functional volume section may provide a power translation or power distribution function.

In an embodiment, at least one of the functional volume sections is configured to provide a power delivery function, in particular provided by a plurality of embedded capacitor components. Embedded passive components embodied as capacitor components may accomplish such a power delivery function. Preferably, a functional volume section providing a power delivery function may extend up to a main surface of the central section or even of the entire IC substrate facing a surface mounted semiconductor chip. Thus, power delivery may occur spatially close to the chip(s).

In an embodiment, the integrated circuit substrate comprises at least one security-related component embedded in at least one of the functional volume sections. In the context of the present application, the term "security-related component" may particularly denote a component providing a security function or contributing to security of the IC substrate or electronic device. Examples of security-related components are a memory with encryption engine, an anti-tamper structure preventing fraudulent handling, a hardware security module, an oscillator or crystal being protected against clock tampering, etc. Preferably, a security-related component may be arranged in an interior of the central section. By hiding such security-related components embedded inside of the central section, a security attack by a non-authorized entity may be rendered more difficult.

In an embodiment, at least one of the functional volume sections comprises at least one heat management structure, in particular for dissipating heat. For instance, such a heat management structure may comprise a heat pipe or a bulky copper block configured for removing heat created during operation of the IC substrate, for instance from one or more surface mounted electronic components.

In an embodiment, at least one of the functional volume sections comprises at least one electrooptical structure. For example, such an electrooptical structure may be a waveguide or an electrooptical transducer, such as a photodiode, a laser or other components used to convert an optical signal into an electrical one such as a digital-analog-converter (DAC), an analog-digital converter (ADC) and/or digital signal processors (DSP).

In an embodiment, the central section comprises or consists of a mechanically stable material, for example fully cured dielectric material, glass, ceramic or a semiconductor. Other materials are possible.

In an embodiment, different functional volume sections provide different, in particular cooperating, functions. Spatial limits of the respective functional volume section may correspond to a spatial range over which the respective function is provided.

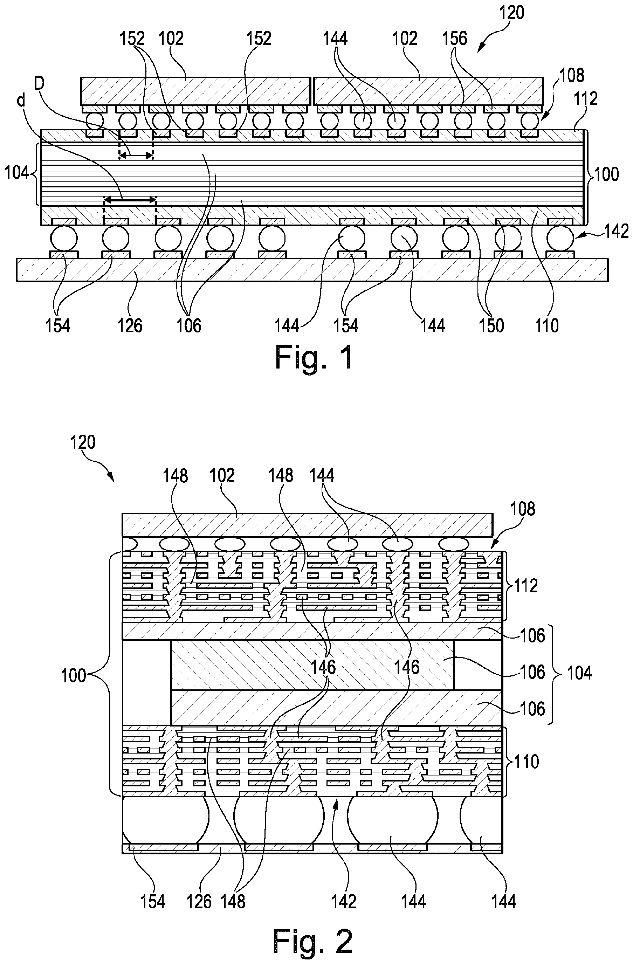

In an embodiment, different ones of the at least two functional volume sections which are placed vertically above each other extend over different vertical spatial extensions. Hence, the technical functions provided by the functional volume sections may also be provided not at the same vertical position or in the same vertical region in the core or may have different relative thicknesses, which fit into the core. For example, such an embodiment is shown in Figure 2. Based on the functionality provided by a respective functional volume section, it may be arranged closer to the top side of closer to the bottom side.

In an embodiment, the integrated circuit substrate comprises at least one electrical and/or mechanical connection structure at least on one main surface of the IC substrate. For instance, solder balls or an arrangement of dots of solder paste may accomplish a connection with surface mounted ICs on the top side and/or a bottom-connected PCB. However, solder balls or the like are optional on an IC substrate, for instance they can be provided on a PCB-type mounting base.

In an embodiment, the electronic device comprises at least one integrated circuit component, in particular a semiconductor element, being surface mounted on the integrated circuit component mounting side. For example, such a semiconductor element may be a bare die, an HBM (high-bandwidth memory), or a silicon interposer. A bare die may be a non-encapsulated (in particular non-molded, more particularly non-overmolded) piece of semiconductor material (such as silicon) having at least one monolithically integrated circuit element (such as a diode or a transistor).

In an embodiment, the integrated circuit component functionally cooperates with at least one of the functional volume sections, in particular with each of the functional volume sections. Such a bare die may be directly mounted on the IC substrate and may be functionally coupled with at least one of the functional volume sections. For instance, a functional volume section may provide a DC-DC conversion between a DC supply voltage provided from a PCB via the IC substrate to a bare die.

In an embodiment, the electronic device comprises a mounting base, in particular a printed circuit board (PCB) or an interposer, on which the integrated circuit substrate is mounted. Such a mounting base may connect the IC substrate and its surface mounted component(s) mechanically and electrically with an electronic periphery, such as the IC substrate mounted on the same mounting base.

In an embodiment, the method comprises monolithically forming the functional volume sections with the central section. Hence, the functional volume sections may be formed by correspondingly configuring a build-up process for forming the central section.

In another embodiment, the method comprises inserting pre-fabricated inlay-type functional volume sections in at least one hole of the central section. Thus, the functional volume sections may be manufactured separately and individually and may then be inserted into a hole of the central section. Advantageously, such inlay-type functional volume sections may be functionally tested before assembly, so that only known-good functional volume sections are assembled, which ensures a high yield.

In an embodiment, at least one of the functional volume sections comprises a metallic slug and/or is a laminated layer stack, in particular comprising at least two stacked layer structures. Preferably, a respective functional volume section may be significantly different from the rest of the central section.

A functional volume section can be, for example, a two layer stack but with different characteristics and/or functionalities than the ones of the main body or central section. In particular, a functional volume section may be configured as at least four stacked layer structures.

For example, a functional volume section embodied as multilayer stack can provide the technical function of an electric connection structure with locally increased integration density as compared to a lower integration density of a surrounding electric connection structure of another functional volume section and/or of the central section. In this context, the term "integration density" may denote a number of electrically conductive elements (in particular trace elements (such as wiring structures), connection elements (such as pads) and/or vertical through connections (such as metallized vias, micro-vias or blind vias) per area or volume of the respective portion. Hence, the amount of electrically conductive elements in a higher density portion may be higher than the amount of electrically conductive elements in a lower density portion. Thus, integration density may mean a quantity of electrically conductive elements per area or volume. The integration density in a lower density portion can be less than in a higher density portion.

It is also possible that such a functional volume section embodied as multilayer stack provides the function of a redistribution structure. A redistribution structure may function as an electric interface between large electrically conductive structures, as characteristic for a PCB, and smaller electrically conductive structures of a surface mounted component, as characteristic for semiconductor technology.

However, it is also possible that a functional volume section comprises a metallic slug, in particular a copper slug. For instance, such a copper slug may provide the technical function of heat removal during operation of the IC substrate or electronic device. This may improve the thermal performance of the IC substrate.

In an embodiment, the central section may comprise or consist of a mechanically stable material, for example fully cured dielectric material, glass, ceramic or a semiconductor.

In an embodiment, the integrated circuit substrate has an exposed substrate pad and has an exposed substrate dielectric, the integrated circuit component has an exposed component pad and has an exposed component dielectric, and the integrated circuit substrate is connected with the integrated circuit component so that there is a direct physical contact between the substrate pad and the component pad and so that there is a direct physical contact between the substrate dielectric and the component dielectric. According to such an embodiment, a package architecture is provided in which a direct physical connection between an integrated circuit substrate and a surface mounted IC-type electronic component is created for establishing an intimate integrally formed connection in between. For this purpose, not only a direct physical connection between exposed pads of electronic component and integrated circuit substrate but also between exposed dielectric surface regions on facing main surfaces of integrated circuit substrate and electronic component may be established by permanent bonding (in particular by hybrid bonding). By such a direct bonding approach, chip assembly on an IC substrate may be significantly simplified over conventional approaches implementing indirect connection techniques such as soldering or sintering. No intermediate material between IC substrate and electronic component may be necessary according to exemplary embodiments of the invention. This contributes to the compactness of the package in vertical direction, since neither solder material nor an interposer needs to be present between IC substrate and IC-type electronic component. Hence, in addition to a simple assembly process, even shorter z-interconnections may be created.

Still referring to the embodiments mentioned in the preceding paragraph, at least one of the following features can be combined with this:
- wherein a connection area between the substrate dielectric and the component dielectric is coplanar with a further connection area between the substrate pad and the component pad.
- wherein the exposed substrate dielectric is formed by a dielectric film, in particular a dielectric oxide film, on a dielectric bulk structure.
- wherein the electronic device is free of any material and/or is free of any gap between the integrated circuit substrate and the electronic component.
- wherein a lateral extension of the substrate pad and/or of the component pad is less than 50 µm, in particular less than 10 µm.
- wherein the component dielectric is formed by a passivation layer of the electronic component or by an additional processed dielectric film on a passivation layer of the electronic component.
- wherein the substrate pad and the component pad are made of the same material.
- wherein the integrated circuit substrate is connected with the electronic component with continuous physical contact over an entire main surface of the electronic component.

In an embodiment, a stack (for instance of the support structure and/or of a laminated layer stack) comprises at least one electrically insulating layer structure and at least one electrically conductive layer structure. For example, the respective stack may be a laminate of the mentioned electrically insulating layer structure(s) and electrically conductive layer structure(s), in particular formed by applying mechanical pressure and/or thermal energy. The mentioned stack may provide a plate-shaped base capable of providing a mounting surface for one or more components and being nevertheless very thin and compact.

In an embodiment, the IC substrate may be shaped as a plate. This contributes to the compact design, wherein the IC substrate nevertheless provides a proper basis for mounting components thereon. Furthermore, in particular a bare die as example for an electronic component, can be conveniently embedded, thanks to its small thickness, into a thin plate-type IC substrate.

The IC substrate may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low DK materials may be applied in the IC substrate as electrically insulating structures.

In an embodiment, the at least one electrically conductive layer structure comprises at least one of the group consisting of copper, aluminum, nickel, silver, gold, palladium, tungsten, magnesium, carbon, (in particular doped) silicon, titanium, and platinum. Although copper is usually preferred, other materials or coated versions thereof are possible as well, in particular coated with supra-conductive material, super-conductive material or conductive polymers, such as graphene or poly(3,4-ethylenedioxythiophene) (PE-DOT), respectively.

At least one further component may be embedded in and/or surface mounted on the respective stack. The component and/or the at least one further component can be selected from a group consisting of an electrically nonconductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al₂O₃) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga₂O₃), indium gallium arsenide (InGaAs), indium phosphide (InP) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in or surface mounted on the IC substrate. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate or an interposer, for example in a board-in-board configuration. The component may be surface mounted on the IC substrate and/or may be embedded in an interior thereof. Moreover, also other components, in particular those which generate and emit electromagnetic radiation and/or are sensitive with regard to electromagnetic radiation propagating from an environment, may be used as component.

In an embodiment, the IC substrate is a laminate. In such an embodiment, the IC substrate is a compound of multiple layer structures which are stacked and connected together by applying a pressing force and/or heat.

After processing interior layer structures of the IC substrate, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or IC substrate.

In particular, an electrically insulating solder resist may be applied to one or both opposing main surfaces of the layer stack or IC substrate in terms of surface treatment. For instance, it is possible to form such a solder resist on an entire main surface and to subsequently pattern the layer of solder resist so as to expose one or more electrically conductive surface portions which shall be used for electrically coupling the IC substrate to an electronic periphery. The surface portions of the IC substrate remaining covered with solder resist may be efficiently protected against oxidation or corrosion, in particular surface portions containing copper.

It is also possible to apply a surface finish selectively to exposed electrically conductive surface portions of the IC substrate in terms of surface treatment. Such a surface finish may be an electrically conductive cover material on exposed electrically conductive layer structures (such as pads, conductive tracks, etc., in particular comprising or consisting of copper) on a surface of a IC substrate. If such exposed electrically conductive layer structures are left unprotected, then the exposed electrically conductive IC substrate material (in particular copper) might oxidize, making the IC substrate less reliable. A surface finish may then be formed for instance as an interface between a surface mounted component and the IC substrate. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), Electroless Nickel Electroless Palladium Immersion Gold (ENEPIG), gold (in particular hard gold), chemical tin (chemical and electroplated), nickel-gold, nickel-palladium, etc. Also nickel-free materials for a surface finish may be used, in particular for high-speed applications. Examples are ISIG (Immersion Silver Immersion Gold), and EPAG (Eletroless Palladium Autocatalytic Gold).

The aspects defined above and further aspects of the invention are apparent from the examples of embodiment to be described hereinafter and are explained with reference to these examples of embodiment.
Figure 1 illustrates a cross-sectional view of an electronic device according to an exemplary embodiment of the invention.
Figure 2 illustrates a cross-sectional view of an electronic device according to another exemplary embodiment of the invention.
Figure 3 illustrates a cross-sectional view of an IC substrate according to an exemplary embodiment of the invention.
Figure 4 illustrates a cross-sectional view of an IC substrate according to another exemplary embodiment of the invention.
Figure 5 illustrates a cross-sectional view and a plan view of an electronic device with an IC substrate according to another exemplary embodiment of the invention.
Figure 6 illustrates a cross-sectional view of an IC substrate according to another exemplary embodiment of the invention.
Figure 7 illustrates a cross-sectional view of an IC substrate according to another exemplary embodiment of the invention.
Figure 8 illustrates a plan view of an IC substrate according to another exemplary embodiment of the invention.
Figure 9 illustrates a cross-sectional view of the IC substrate according to Figure 8 along a line A-A.
Figure 10 illustrates a cross-sectional view of the IC substrate according to Figure 8 along a line B-B.
Figure 11 illustrates a schematic view of an electronic device according to another exemplary embodiment of the invention.
Figure 12 illustrates a schematic view of an electronic device according to another exemplary embodiment of the invention.
Figure 13 illustrates a cross-sectional view of an electronic device according to another exemplary embodiment of the invention.

The illustrations in the drawings are schematic. In different drawings, similar or identical elements are provided with the same reference signs.

Before, referring to the drawings, exemplary embodiments will be described in further detail, some basic considerations will be summarized based on which exemplary embodiments of the invention have been developed.

According to an exemplary embodiment of the invention, an IC substrate (having a characteristic pitch of not more than 150 µm, preferably less) for surface mounting a bare semiconductor chip is provided. Advantageously, such an IC substrate comprises a (preferably core-type) central section with vertically stacked functional volume sections arranged therein. Such an architecture may make it possible to obtain an IC substrate with highly compact design which simultaneously provides a sophisticated electronic functionality being flexibly configurable by correspondingly selecting the implemented functional volume sections. By integrally forming (as stack portions) or embedding (as pre-fabricated inlays) functional volume sections in a central section of the IC substrate, additional functionality may be integrated specifically in those regions where needed for a specific application.

The described approach has advantages: By splitting an IC substrate into separate sections with specific functions, a functional optimization of the IC substrate volume may be achieved. Such an architecture may be versatile and may allow an efficient material usage and design for individual functional sections. By an appropriate material choice of the central section, warpage may be efficiently suppressed. Multiple functions can be added or stacked to the core construction. Each functional volume section or sub-core can be tested independently, so that only known-good functional volume sections are further processed. This may lead to a high yield. Furthermore, it may be possible, by the provision of an interface layer, to decouple laser via positions from positions of through holes in a core-type central section.

According to exemplary embodiments of the invention, any of the functions and sub-functions, alone or in any combination, mentioned in the following may be integrated in any functional volume section of an integrated circuit substrate:
- Security function:
   - Embedding of memory with engines for encryption or for storing sensitive data (such as VPD/keywords/identifier)
   - Construction of anti-tamper structure to avoid fraudulent handling of the hardware
   - Integration to obtain a Hardware Security Module (HSM)
   - Embedding of oscillator and/or crystal to avoid tamper of clock functions
   - Protect all the above with the creation of a sensing network between devices and external accessible layers
- Thermal management function:
   - Integration of heat-dissipative structures (for example copper slugs, thermal inlay)
   - Multiple laser vias construction to increase thermal transfer
   - Integration of heat-pipe(s) within one of the multi-functional sub-cores (i.e. functional volume sections)
- Electrical function:
   - Embedding of capacitances in areas close to a point of load of a microprocessor or an accelerator
   - Embedding of other passive components to create filters
   - Highly effective partitioning of the metal features supporting power domains
   - Fully plated mechanical holes filled with copper for lower resistivity and higher ampacity (in particular, ampacity may denote a current-carrying capacity and in particular a maximum current that a conductor can carry continuously under the conditions of use without exceeding its temperature rating)
   - Power networking distribution of power through thick planes
   - Different copper thicknesses in different sub-cores
   - Different drill diameters in the sub-cores for power feeding structures
   - Flexibility in the wiring of structures (laser vias stacking) not influenced by the positioning of plated through holes
- Structural function:
   - Sub-cores can have cavities (for instance for creating resonators, waveguides)
   - Physical separation of analog circuits from digital circuits
   - Sub-cores can be made of different dielectric materials (including glass)
   - Every sub-core can be tested prior of its use in the stacking of the multi-functional core
   - Sub-cores can be constructed so that embedded components are enclosed into a Faraday cage (for instance by cavity plating, formation of a via fence)
   - Different copper thicknesses in different sub-cores
   - Different drill diameters in the sub-cores for power feeding structures
- Electrooptical integration function:
   - Sub-core(s) can be designed to host optical waveguides, mirrors, coupling schemes like adiabatic coupling
   - Sub-core can be designed to host an optical connector to receive or to inject optical signal to and/or from external

The multifunctional core may be provided with security, authentication and/or integrity functions. Some aspects related to hardware security and being implemented according to exemplary embodiments are the following:
In an embodiment, it may be possible to embed, in any of the functional volume sections, one or more memory devices (for example an EEPROM) with one or more engines for encryption or for storing sensitive data (such as VPD, keywords, identification data, etc.).

In an embodiment, it may be possible to implement, in any of the functional volume sections, an anti-tamper structure to avoid fraudulent handling of the hardware. For instance, it may be possible to implement, in any of the functional volume sections, a Hardware Security Module (HSM). It is also possible to embed, in any of the functional volume sections, one or more oscillators and/or crystals to avoid tamper of clock functions.

Furthermore, it may be possible in an embodiment to protect any of the above security features with the creation of a sensing network between devices and external accessible layers.

Security related equipment, such as electronic devices according to exemplary embodiments of the invention, are prone to hacking where the hacker may want to extract information and/or modify the internal settings. Such methods may include tweaking the time so as to fool the system. As an example, a hacker may force faulty outputs of devices implementing cryptographic elements in order to reveal some secret information. Tampering with the clock signal or the supply voltage are techniques for generating erroneous behavior. It may also be possible to analyze the vulnerability of two different microcontroller platforms on clock and supply voltage tampering.

A real-time clock (RTC) is a computer clock that keeps track of the current time. RTCs are used in personal computers, servers and embedded systems and any electronic device that requires an accurate time keeping and/or monitoring. Hackers can change the RTC crystal so as to count less, as RTC usually relies on a 32.768 kHz external crystal oscillator, or simply removing it to stall the time counting. This introduces inaccuracies in measurement and thus security. For electronic devices according to exemplary embodiments of the invention, avoiding the above may be of utmost advantage.

Generally, critical data like security keys, passwords, etc., are retained in a battery backed up memory within a silicon on-chip or RTC registers since they are available all the time even in the event of main power failure. It is important that this should not go into the hands of a hacker. Hence during any tamper detection, RTC may erase all the secure keys stored in its registers and the contents of any associated secure memory. The RTC crystal may be subjected to changes in pressure, voltage, temperature or may be subjected to certain chemicals so as to change crystal characteristics thus running the clock slower or faster.

According to an exemplary embodiment of the invention, securing an RTC device and the external associated crystal within one of the functional volume sections of the multi-functional core delivers a more complex configuration to any hacking attempt due to the quite difficult task of reaching the components without compromising other functions included in the design or construction of the integrated circuit substrate. Moreover, for some applications, the RTC clocking crystal can provide a 32.768 kHz clocking to the MCUs avoiding the requirement of a main crystal to be mounted on the board (in particular externally) to the module.

**Figure 1** illustrates a cross-sectional view of an electronic device 120 according to an exemplary embodiment of the invention.

The illustrated electronic device 120 comprises a central integrated circuit substrate 100, also denoted as IC substrate. Furthermore, the electronic device 120 comprises integrated circuit components 102 which are here configured as bare dies (i.e. non-encapsulated semiconductor chips) and which are surface mounted on a top main surface of the IC substrate 100, i.e. at an integrated circuit component mounting side 108 thereof. In the shown embodiment, two IC components 102 are surface mounted on the IC substrate 100. The IC components 102 may be configured as semiconductor chips, for instance active semiconductor chips. Examples of the IC components 102 are processors, memories, sensors, logic chips, microelectromechanical systems (MEMS), etc.

On a bottom side of the electronic device 120, a mounting base 126 is provided on which the IC substrate 100 is mounted. For example, the mounting base 126 may be a printed circuit board (PCB) or an interposer. Although not shown in Figure 1, further components (such as further IC substrates, further (in particular molded) semiconductor chips, etc.) may be assembled on the mounting base 126.

As shown in Figure 1 as well, electric connection structures 144 may be formed on both opposing main surfaces of the IC substrate 100. For instance, said electric connection structures 144 may be solder balls or solder bumps or copper pillars, or may be configured as sinter structures (for instance may be formed based on sinter paste). The electric connection structures 144 on the bottom main surface of the integrated circuit substrate 100 are connected electrically and mechanically with bottom-sided pads 150 of the IC substrate 100. As shown, a pitch, d, between adjacent bottom-sided pads 150 may be larger than a pitch, D, between adjacent top-sided pads 152 of the IC substrate 100. In other words, pitch D of a laminated layer stack 112 facing the integrated circuit component mounting side 108 is smaller than pitch d of laminated layer stack 110 being remote from the integrated circuit component mounting side 108. Correspondingly, a mutual distance between adjacent electric connection structures 144 is smaller on a top side of the IC substrate 100 than on a bottom side. To put it shortly, the pitch, d, of for example the 250 µm matches with the requirements of PCB technology, whereas the pitch, D, of for example 100 µm matches with the requirements of semiconductor technology. More generally, pitch, D, at the integrated circuit component mounting side 108 of the integrated circuit substrate 100 may be not more than 150 µm, in particular not more than 100 µm. Correspondingly, pitch, d, at mounting base mounting side 142 of the integrated circuit substrate 100 may be more than 200 µm, in particular more than 300 µm. As shown, the bottom-sided pads 150 are electrically coupled with mounting base pads 154 of mounting base 126 by the bottom-sided electric connection structures 144. Correspondingly, the top-sided pads 152 of the IC substrate 100 are electrically coupled with chip pads 156 of the IC components 102 by the top-sided electric connection structures 144.

It should be mentioned that the solder balls connecting the IC substrate 100 and the IC components 102 may be smaller than the solder balls connecting the IC substrate 100 with the mounting base 126.

In the following, construction of the IC substrate 100 will be explained in further detail:
The integrated circuit substrate 100 comprises a central section 104, which may also be denoted as support structure and which can be embodied as a core comprising fully cured dielectric material.

As shown, the central section 104 is composed of three vertically stacked functional volume sections 106. However, the number of vertically stacked functional volume sections 106 may also be two or at least four. In the embodiment of Figure 1, each of the stacked functional volume sections 106 extends over the entire width of the central section 104. As a result, each of the functional volume sections 106 provides mechanical support as well as a dedicated technical function in view of the specific configuration of the respective functional volume section 106. Hence, the shown configuration uses the available volume of the multifunctional central section 104 highly efficiently.

For example, three vertically stacked functional volume sections 106 can be constructed very simply by one central core and one prepreg added on either side of the core (as a physical demarcation). However, it is also possible that three vertically stacked functional volume sections 106 provide a very complex multi-cores structure where the three sections are identified by their different functionalities. Hence, these may provide a functional demarcation of the functional volume.

According to Figure 1, possible functions which may be implemented in the functional volume sections 106 may be in particular the following:
- lower functional volume section 106: power conversion with embedded active components (for instance by a core-integrated DC-DC converter)
- middle functional volume section 106: power translation or power distribution (optionally with thicker copper possible); in particular, a corebased redistribution layer may be formed in this functional volume section 106 for transferring from a larger to a smaller pitch
- upper functional volume section 106: power delivery with embedded capacitances (advantageously, this task can be fulfilled closer to a point of load or delivery to the surface mounted chips).

More generally, examples for functional volume sections 106 are :
- signal routing (in particular for high-speed applications)
- power delivery (in particular by multilayer structures, embedded passive components, etc.)

- thermal functionality (for instance by heat-removing copper slugs)
- an electro-optical transducing function
- formation of an organic or silicon bridge (for instance for fine line structures)
- antenna or other high-frequency functions

One, some or all of the functional volume sections 106 may be laminated layer stacks configured in accordance with their dedicated functions, and optionally having one or more embedded components (such as semiconductor chips). One, some or all of the functional volume sections 106 may extend vertically over a plurality of stacked layer structures, for instance at least two or at least four. Different functional volume sections 106 may provide different, in particular cooperating, functions.

As shown in Figure 1 as well, the IC substrate 100 comprises laminated layer stack 110 on a bottom main surface of the central section 104 and its functional volume sections 106. Furthermore, further laminated layer stack 112 may be formed on an opposing other (upper) main surface of the central section 104 and its functional volume sections 106. Hence, a further build-up may be formed on one or both opposing main surfaces of the central section 104 and on the functional volume sections 106. Any of the laminated layer stacks 110, 112 may comprise one or more electrically conductive layer structures (such as patterned copper foils which may form horizontal pads and/or a horizontal wiring structure, and/or vertical through connections such as copper pillars and/or copper filled laser vias) and one or more electrically insulating layer structures (such as prepreg or resin sheets). For example, the laminated layer stack 110 and/or the further laminated layer stack 112 may have a larger integration density than the central section 104 with the integrated functional volume sections 106. Advantageously, it is also possible that the bottom-sided laminated layer stack 110 has a lower integration density than the top-sided further laminated layer stack 112. Hence, a locally higher integration density may be formed next to the surface mounted IC components 102 having a high integration density as well. However, a lower integration density may be sufficient next to the mounting base 126 with its lower integration density being characteristic for PCB-technology. This may allow to manufacture the central section 104 with low effort and to provide one or more regions of higher integration density only when needed. For instance, any of the optional layer stacks 110, 112 may contribute to a mechanical strengthening and/or formation of a redistribution layer in the framework of the electronic device 120.

Instead of providing a substrate with an undifferentiated core construction, the shown embodiment provides different sub-cores with specific functions. Some of the functions can be integrated into an arrangement of prepreg sheets and core(s) or into multiple cores. To put it shortly, it may be possible to monolithically form the functional volume sections 106 with the central section 104, so that the functional volume sections 106 form sub-portions, in particular sub-cores.

**Figure 2** illustrates a cross-sectional view of an electronic device 120 according to another exemplary embodiment of the invention.

The embodiment of Figure 2 differs from the embodiment of Figure 1 in particular in that, according to Figure 2, the vertical thickness of the different functional volume sections 106 is different. Furthermore, the ranges over which the individual functional volume sections 106 extend according to Figure 2 are different. This shows the high degree of flexibility of the modular functionality in central section 104.

Furthermore, Figure 2 shows that the laminated layer stacks 110, 112 can be composed of a plurality of electrically conductive layer structures 146 and of electrically insulating layer structures 148. The electrically conductive layer structures 146 may comprise patterned copper foils which may form horizontal pads and/or a horizontal wiring structure. Additionally or alternatively, the electrically conductive layer structures 146 may comprise vertical through connections such as copper pillars and/or copper filled laser vias. Moreover, the laminated layer stacks 110, 112 may comprise one or more electrically insulating layer structures 148 (such as prepreg or resin sheets).

Still referring to Figure 2, a vertical thickness of a respective electrically insulating layer structure 148 in any of the laminated layer stacks 110, 112 may be in a range from 20 µm to 50 µm, for example 40 µm. For example, a vertical thickness of the central section 104 may be in a range from 400 µm to 1600 µm, preferably in a range from 650 µm to 1200 µm. A typical thickness of the solder bumps facing the mounting base 126 may be 400 µm.

**Figure 3** illustrates a cross-sectional view of an IC substrate 100 according to an exemplary embodiment of the invention. According to Figure 3, two stacked functional volume sections 106 are provided which each comprise a vertical through connection 116 extending vertically only through part of the thickness of the central section 104. It can also be seen that each of the functional volume sections 106 comprises a horizontally extending wiring structure 118.

**Figure 4** illustrates a cross-sectional view of an IC substrate 100 according to another exemplary embodiment of the invention. In the embodiment of Figure 4, similar functional features as according to Figure 3 are provided by three functional volume sections 106 being vertically stacked on top of each other.

Again referring to Figure 3 and Figure 4, multifunctional cores according to exemplary embodiments are shown which may form part of an IC circuit substrate 100. Each multifunctional sub-core may be independently tested concerning its functionality (when providing active duty) prior of its commitment to full assembly into the multifunctional core. Preferably, a corresponding manufacturing method may comprise testing (in particular electrically or functionally testing) a pre-fabricated functional volume section 106 individually before assembling such a functional volume section 106 to a central section 104. By testing a pre-fabricated functional volume section before assembling it to a central section 104, it may be ensured that only known-good functional volume sections 106 form part of the readily manufactured electronic device 120. This may allow to preserve a final yield or a significant mitigation of cumulative impacts in sequential operations.

A top added layer may allow a decoupling of positioning between plated through holes and laser vias connecting the core to the build-up layers (see also the description of Figure 5).

Advantageously, the presence of multi layers of copper may act in favor of mechanical rigidity and stability. Preferably, copper structures can be made as thick as in traditional double side cores, thereby matching with existing infrastructure at module level. Reduced thickness goes toward the possibility of filling holes with copper thanks to a reduced aspect ratio for plating of the holes.

Different sub-cores can have different copper layer thicknesses to improve the construction of power delivery networks. Moreover, different sub-cores can be used for shielding to prevent cross-talk through the core.

Moreover, any sub-core can embed one or more active and/or passive components for constructing full electrical functions which may be otherwise only available at PCB level. Copper thickness may be equal on both sides (for instance in the range from 9 µm to 35 µm).

**Figure 5** illustrates a cross-sectional view and a plan view of an electronic device 120 with an IC substrate 100 according to another exemplary embodiment of the invention.

Firstly, it can be taken from Figure 5 that dimensions of laser vias 160 and dimensions of plated through holes 162 in a dielectric matrix 159 of the core of the IC substrate 100 are very different. For example, laser via land diameters may be 60 µm, whereas a diameter of plated through hole lands may be 350 µm.

Furthermore, Figure 5 shows wiring traces 164 on or above an interface layer 128 in an interface region between central section 104 and laminated layer stack 112. Interface layer 128 may still form part of the central section 104 and may be located at a top portion thereof. Thus, wiring can be created very close to the core. More generally, by integrating functional features in the core or central section 104, exterior layers can be used more efficiently, a layer count may be reduced, a higher density may be achieved and/or size of the IC substrate 100 may be reduced. In particular, interface layer 128 of the central section 104 may decouple geometrically the position of the laser vias 160 with respect to the through holes 162.

The wiring traces 164 can be wired on a layer above the interface layer 128, which is already providing a higher level of electrical (plane) reference, as well as of shielding the traces 164 from the electrical discontinuities created by the design geometries (lands and isolation gaps) of the through holes 162. Hence, there are less restrictions to avoid crossing of gaps in the filled areas of the interface layer 128. Advantageously, one layer on each side of the stack may be removed from its shielding duty and to be directly assigned to signal wiring as otherwise, it would be required in comparison with conventional approaches. Hence, interface layer 128 may become a reference plane to allow wiring on one layer above resulting in the reduction of the number of laminated layers required to maintain the three-layers-structure of placing signal layers in between 2 reference planes (Reference - Signal - Reference), where reference plane means a metal area assigned to a non-switching power voltage domain or a ground potential. The laser vias 160 shown in Figure 5 represent possible locations for laser vias connecting layers. Their position on the interface layer 128 and one layer above are no longer constrained by the same rules for reliability not being constructed onto an ABF (Ajinomoto ^{®} Build-up Film) layer but on the ones governing a high density integration (HDI) glass reinforced prepreg. Moreover, their position may have a greater degree of freedom for the possibility of creating a full via-stack to reach the semiconductor bump, the latter having a very different pitch compared to the minimum pitch allowed for the plated through hole.

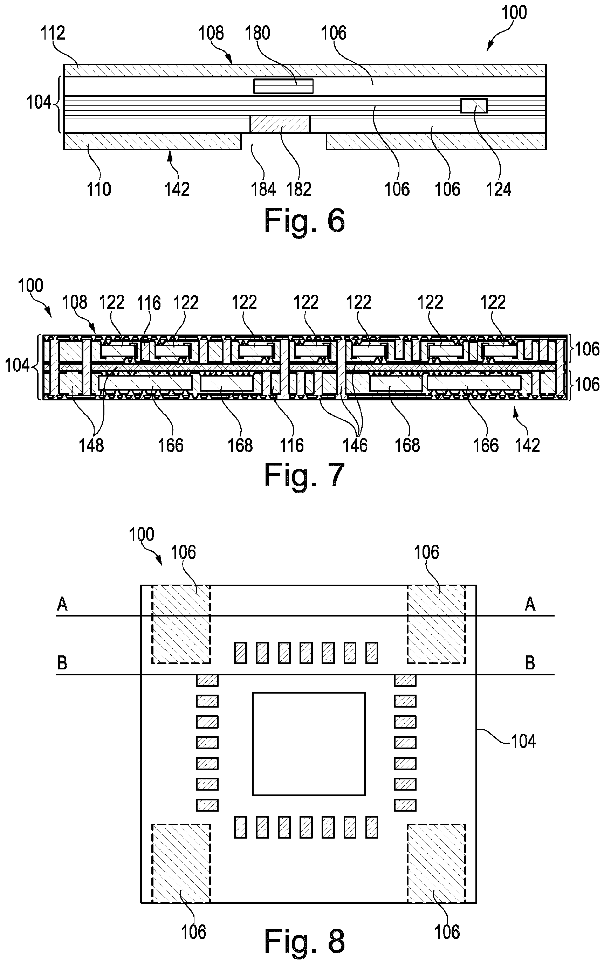

**Figure 6** illustrates a cross-sectional view of an IC substrate 100 according to another exemplary embodiment of the invention.

To put it shortly, Figure 6 illustrates IC substrate 100 of Figure 1 without IC components 102 and without mounting base 126. Furthermore, a recess 184 may be optionally formed in a lower main surface of the IC substrate 100 according to Figure 6 as an electro-optical input. Additionally or alternatively to an electro-optical input at a main surface of the IC substrate 100, it may also be possible to have a lateral electro-optical input, for instance at a sidewall of the IC substrate 100. For example, this may be accomplished by a pipe and/or an optical plug.

As shown as well in Figure 6, one or more security-related components 124 may be embedded in one of the functional volume sections 106, preferably in the middle of the stacked functional volume sections 106. For instance, the illustrated security-related component 124 may be a crypto engine, an anti-tamper structure, or a clock generator protected against tampering, etc. By embedding security-related component 124 in an interior of the integrated circuit substrate 100, a security attack by an unauthorized entity may be made more difficult since it would require access to embedded security-related component 124, which is difficult without destroying IC substrate 100.

Furthermore, the uppermost one of the functional volume sections 106 in Figure 6 comprises a heat management structure 180, such as a bulky copper block or a heat pipe. Hence, the heat management structure 180 may be located directly beneath the position where a surface mounted electronic component 102 is to be mounted and can therefore efficiently remove heat therefrom.

Moreover, the lowermost functional volume section 106 comprises an exposed electrooptical structure 182. Electrooptical structure 182 may for instance comprise an electrooptical transducer, such as a photodiode, configured for converting an optical signal supplied from a bottom side into an electric signal for further processing by the integrated circuit substrate 100 and/or by an electronic component 102 being surface mounted thereon. It is also possible that the electrooptical structure 182 comprises an optical fiber for transmitting and/or receiving an optical signal.

In a transducer, there may be several components. As a signal may be digital but light may be actually analog, an analog/digital converter and a digital/analog converter may be implemented. Furthermore, a digital signal processor may be implemented to distribute the data into different signal lanes. All these functions can be integrated in one IC component or in different IC components. Furthermore, photodiodes may translate optical signals into electrical ones, but optical signals may be generated by a laser or an external light source. Modulation of such a light may also be possible, which may be done with driver IC components controlling the laser itself or modulators on a photonic IC.

**Figure 7** illustrates a cross-sectional view of an IC substrate 100 according to another exemplary embodiment of the invention.

According to Figure 7, the lower functional volume section 106 comprises a power converter function embodied as a direct current-direct current-converter function. For this purpose, the lower functional volume section 106 according to Figure 7 comprises embedded components, here embodied as active components 166 and passive components 168. For instance, active components 166 may be DC-DC-converter chips, whereas passive components 168 may be inductor components. Together, components 166, 168 embedded in the lower functional volume section 106 may provide a power conversion function, more specifically a direct current-direct current-converter function. To put it shortly, the shown configuration may provide a core-integrated DC-DC-converter.

Furthermore, the upper functional volume section 106 comprises a power delivery function provided by a plurality of embedded capacitor components 122. Descriptively speaking, the embedded capacitor components 122 may provide a power delivery function at a highly appropriate position inside of the stack-type central section 104 (in particular more appropriate than in a surface mounted manner, as in conventional approaches).

An intermediate portion between the upper and the lower functional volume sections 106 may be configured as redistribution structure arranged vertically between a power conversion section and a power delivery section.

**Figure 8** illustrates a plan view of an IC substrate 100 according to another exemplary embodiment of the invention.

The plan view of Figure 8 shows that dedicated areas may be specified in which certain functional volume sections 106 can be advantageously accommodated. The configuration according to Figure 8 corresponds to the areas being suitable for the embedding of DC/DC units (i.e. providing the function of the lower functional volume section 106 according to Figure 7).

As shown in Figure 8, direct current-direct current converter-related blocks may be embedded in corner regions of the central section 104 only. Hence, a regional partitioning of multifunctional sub-cores may be carried out.

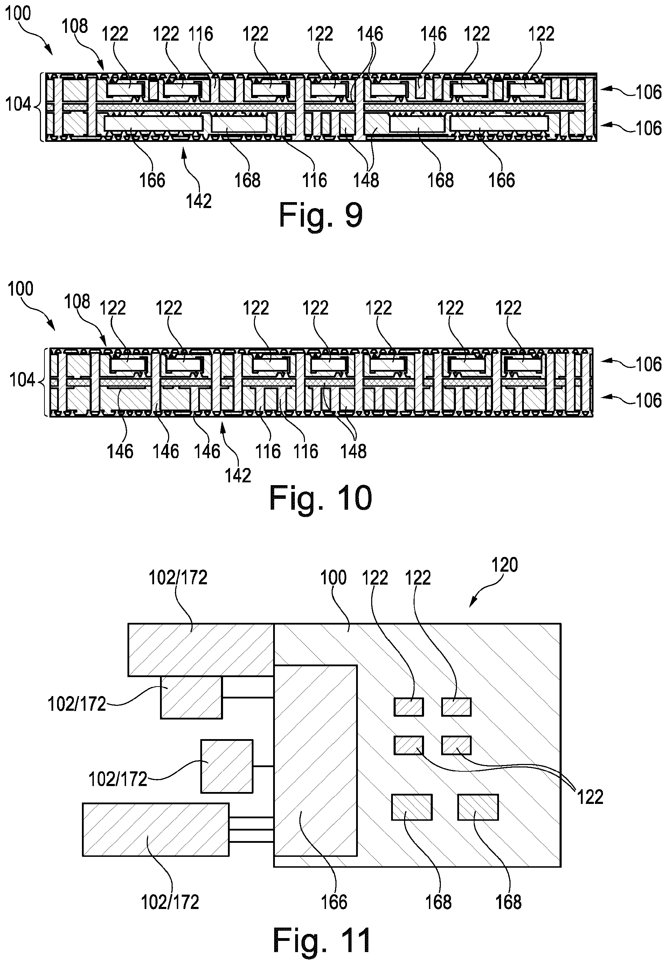

**Figure 9** illustrates a cross-sectional view of the IC substrate 100 according to Figure 8 along a line A-A. **Figure 10** illustrates a cross-sectional view of the IC substrate 100 according to Figure 8 along a line B-B.

**Figure 11** illustrates a schematic view of an electronic device 120 according to another exemplary embodiment of the invention.

The schematic illustration of Figure 11 relates to the application of a DC-DC stackable converter circuit that can be embedded. For example, components 122, 166, 168 may be embedded in a central section 104 of IC substrate 100. Additional components functionally cooperating with IC substrate 100 can be surface mounted on the IC substrate 100 - see reference sign 102 - and/or can be mounted on a mounting base 126 (such as a PCB or a motherboard) - see reference sign 172.

For example, a plurality of DC-DC-convertors may provide a supply voltage to a central processing unit (CPU).

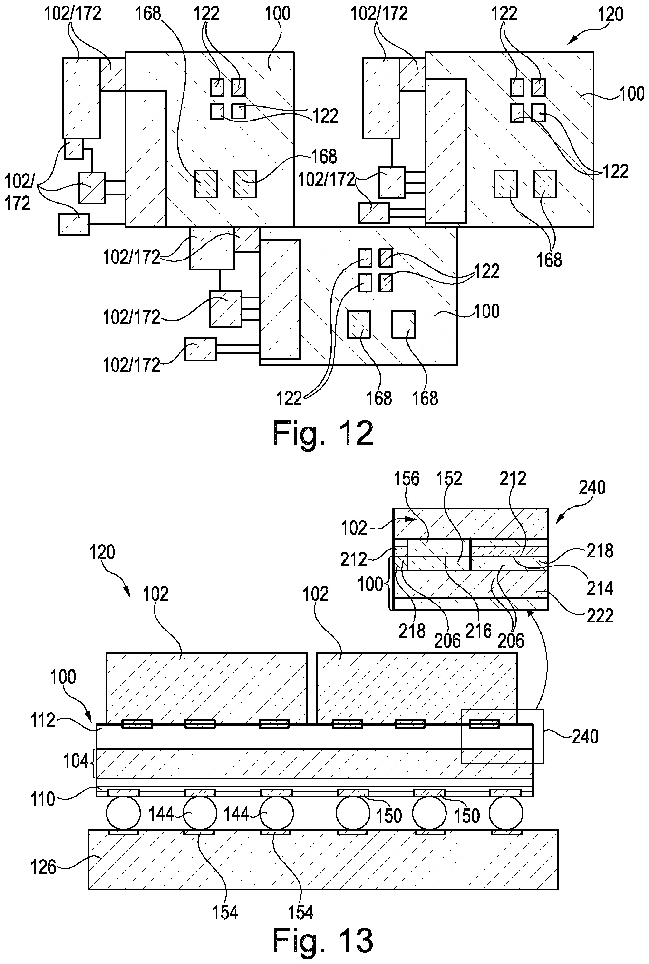

**Figure 12** illustrates a schematic view of an electronic device 120 according to another exemplary embodiment of the invention.

Basically, Figure 12 shows a configuration of three electronic devices 120 according to Figure 11, which can be for instance mounted on a common mounting base 126 (not shown).

**Figure 13** illustrates a cross-sectional view of an electronic device 120 according to another exemplary embodiment of the invention.

The illustrated electronic device 120 comprises an integrated circuit substrate 100 and comprises two electronic components 102 mounted with full-surface direct physical contact on the integrated circuit substrate 100.

On a bottom side of the electronic device 120, a mounting base 126 is provided on which the IC substrate 100 is mounted.

The integrated circuit substrate 100, the at least one electronic component 102 and/or the mounting base 126 can be constructed according to any of the above described figures.

A detail 240 in Figure 13 shows particularities of the connection surface between the integrated circuit substrate 100 and one of the electronic components 102. As shown in detail 240, the electronic device 120 is free of any material and is free of any gap between the integrated circuit substrate 100 and the electronic component 102 which are connected with each other over a continuous connection area. Thus, the integrated circuit substrate 100 may be connected with the electronic components 102 with continuous physical contact over an entire main surface of the electronic components 102.

Still referring to Figure 13 and in particular to detail 240, the integrated circuit substrate 100 comprises in its upper portion a plurality of exposed substrate pads 152 being surrounded by an exposed substrate dielectric 206. For instance, each of the substrate pads 152 is made of copper material. The exposed substrate dielectric 206 may for instance be organic dielectric material, such as epoxy resin. In the connected state according to Figure 13, exterior planar surface portions of the exposed substrate dielectric 206 and of the exposed substrate pads 152 may be coplanar and at the same vertical level. The avoidance of protrusions and depressions in the substantially flat connection surface between integrated circuit substrate 100 and electronic components 102 may ensure a reliable electric connection as well as an avoidance of cracks.

Still referring to detail 240, the illustrated electronic component 102 has exposed component pads 156 and has an exposed component dielectric 212. For instance, each of the component pads 156 is made of copper material. Advantageously, the material of the substrate pads 152 and of the component pads 156 may be the same which may promote a firm pad-pad connection and thus a good reliability of electronic device 120. The exposed component dielectric 212 may for instance be a passivation layer made of a polymer dielectric material.

In the connected state according to Figure 13, exterior planar surface portions of the exposed component dielectric 212 and of the exposed component pads 156 may be coplanar, i.e. at the same vertical level. Furthermore, exterior planar surface portions of the exposed component pads 156 and of the exposed substrate pads 152 may be coplanar and at the same vertical level as dielectrics 206, 212. Hence, a connection area 214 between the substrate dielectric 206 and the component dielectric 212 is coplanar with a further connection area 216 between the substrate pad 152 and the component pad 156.

As shown in detail 240 as well, the integrated circuit substrate 100 is connected with the illustrated electronic component 102 so that there is a direct physical contact between the substrate pads 152 and the component pads 156. Furthermore, the connection is executed so that there is a direct physical contact between the substrate dielectric 206 and the component dielectric 212. Advantageously, no additional material (such as solder) or element (for instance an interposer) is arranged between the integrated circuit substrate 100 and the electronic components 102. This keeps the vertical dimension of electronic device 120 small so that a compact design may be achieved. Furthermore, this direct connection keeps the electric connection paths short, thereby ensuring high signal integrity and low losses as well as a strong suppression of excessive electronic device heating. Consequently, electronic device 120 may be provided with high thermal, mechanical and electrical reliability.

In the illustrated embodiment, the exposed substrate dielectric 206 can be formed by a thin dielectric film 218, which can be preferably a dielectric oxide film formed by oxidizing a dielectric surface portion of the integrated circuit substrate 100. The thin dielectric film 218 may be arranged on a thick dielectric bulk structure 222 of the integrated circuit substrate 100. By forming the exposed substrate dielectric 206 with a very smooth thin dielectric film 218, excellent adhesion properties between integrated circuit substrate 100 and the respective IC-type electronic component 102 may be achieved.

As shown, the bottom-sided pads 150 are electrically coupled with mounting base pads 154 of mounting base 126 by bottom-sided electric connections structures 144 (such as solder balls). In contrast to this, the top-sided substrate pads 152 are directly electrically coupled with the component pads 156 of the IC components 102, i.e. without top-sided electric connections structures (i.e. without solder balls or the like).

It should be noted that the term "comprising" does not exclude other elements or steps and the "a" or "an" does not exclude a plurality. Also, elements described in association with different embodiments may be combined.

It should also be noted that reference signs in the claims shall not be construed as limiting the scope of the claims.

Implementation of the invention is not limited to the preferred embodiments shown in the figures and described above. Instead, a multiplicity of variants is possible which use the solutions shown and the principle according to the invention even in the case of fundamentally different embodiments.

## Claims

1. An integrated circuit substrate (100) for surface mounting an integrated circuit component (102) thereon, wherein the integrated circuit substrate (100) comprises:
a central section (104); and
at least two vertically stacked functional volume sections (106) in the central section (104);
wherein a pitch (D) at an integrated circuit component mounting side (108) of the integrated circuit substrate (100) is not more than 150 µm.

2. The integrated circuit substrate (100) according to any of claims 1, comprising a laminated layer stack (110, 112) formed on one main surface of the central section (104).

3. The integrated circuit substrate (100) according to claim 2, comprising a further laminated layer stack (112, 110) formed on an opposing other main surface of the central section (104).

4. The integrated circuit substrate (100) according to claim 2 or 3, wherein the laminated layer stack (110, 112) and/or the further laminated layer (112, 110) stack has a different integration density than the central section (104).

5. The integrated circuit substrate (100) according to claim 3 or 4, wherein a pitch (D) of the laminated layer stack (112) facing the integrated circuit component mounting side (108) is smaller than a pitch (d) of the further laminated layer stack (110) being remote from the integrated circuit component mounting side (108).

6. The integrated circuit substrate (100) according to any of claims 3 to 5, wherein the central section (104) comprises an interface layer (128) in an interface region between the central section (104) and the laminated layer stack (110, 112) that decouples geometrically a position of through holes (162) of the central section (104) with respect to laser vias (160) of the laminated layer stack (110, 112).

7. The integrated circuit substrate (100) according to any of claims 1 to 6, wherein at least one of the functional volume sections (106) comprises a power converter function, in particular a direct current-direct current-converter function.

8. The integrated circuit substrate (100) according to any of claims 1 to 7, comprising at least one of the following features:
wherein at least one of the functional volume sections (106) comprises a power distribution function, in particular a redistribution structure;
wherein at least one of the functional volume sections (106) comprises a power delivery function, in particular provided by a plurality of embedded capacitor components (122);
comprising at least one security-related component (124) embedded in at least one of the functional volume sections (106), preferably in an interior of the central section (104);
wherein at least one of the functional volume sections (106) comprises at least one heat management structure (180), in particular for dissipating heat;
wherein at least one of the functional volume sections (106) comprises at least one electrooptical structure (182);
wherein the central section (104) comprises or consists of a mechanically stable material, for example fully cured dielectric material, glass, ceramic or a semiconductor.

9. The integrated circuit substrate (100) according to any of claims 1 to 8, wherein different functional volume sections (106) provide different, in particular cooperating, functions.

10. An electronic device (120) comprising an integrated circuit substrate (100) according to any of claims 1 to 9.

11. The electronic device (120) according to claim 10, comprising an integrated circuit component (102), in particular a semiconductor element, being surface mounted on the integrated circuit component mounting side (108).

12. The electronic device (120) according to any of claims 10 to 11, comprising a mounting base (126), in particular a printed circuit board or an interposer, on which the integrated circuit substrate (100) is mounted.

13. The electronic device (120) according to any of claims 11 to 12,
wherein the integrated circuit substrate (100) has an exposed substrate pad (152) and has an exposed substrate dielectric (206);
wherein the integrated circuit component (102) has an exposed component pad (156) and has an exposed component dielectric (212);
wherein the integrated circuit substrate (100) is connected with the integrated circuit component (102) so that there is a direct physical contact between the substrate pad (152) and the component pad (156) and so that there is a direct physical contact between the substrate dielectric (206) and the component dielectric (212).

14. A method of manufacturing an integrated circuit substrate (100) for surface mounting an integrated circuit component (102) thereon, wherein the method comprises:
providing a central section (104);
vertically stacking at least two functional volume sections (106) in the central section (104); and
forming a pitch (D) at an integrated circuit component mounting side (108) of the integrated circuit substrate (100) being not more than 150 µm.

15. The method according to claim 14, comprising one of the following features:
wherein the method comprises monolithically forming the functional volume sections (106) with the central section (104);
wherein the method comprises inserting pre-fabricated inlay-type functional volume sections (106) in at least one hole of the central section (104).
